# EUROPEAN PATENT SPECIFICATION

(11) **EP 0 678 969 B1**
(45) Date of publication and mention of the grant of the patent: **15.03.2000**
(21) Application number: 95105547.4
(22) Date of filing: 12.04.1995
(51) Int. Cl.: H02M 3/07, H03K 19/0944

(54) **BiMOS semiconductor integrated circuit having boosted voltage line**
BIMOS integrierte Halbleiterschaltung mit erhöherter Speisespannung
Circuit intégré semi-conducteur BIMOS avec tension d'alimentation surélevée

(30) Priority: 18.04.1994 JP 7829794
(43) Date of publication of application: 25.10.1995
(73) Proprietor: NEC CORPORATION, Tokyo (JP)
(72) Inventor: Okamura, Hitoshi, Minato-ku, Tokyo (JP)
(74) Representative: Baronetzky, Klaus, Dipl.-Ing.

(56) References cited:
- EP-A- 0 307 323
- US-A- 4 794 280

## Description

### Background of the Invention

### 1. Field of the Invention

The present invention relates to a semiconductor integrated circuit such as a so-called BiCMOS or BiNMOS semiconductor circuit in which bipolar transistors and Metal-Oxide-Semiconductor (MOS) Field Effect Transistors (FETs) are integrated on the same semiconductor substrate (to be referred to as "BiMOS semiconductor integrated circuit" hereinafter). More particularly, the present invention relates to a BiMOS semiconductor integrated circuit in which a boosted voltage is used.

### 2. Description of Related Art

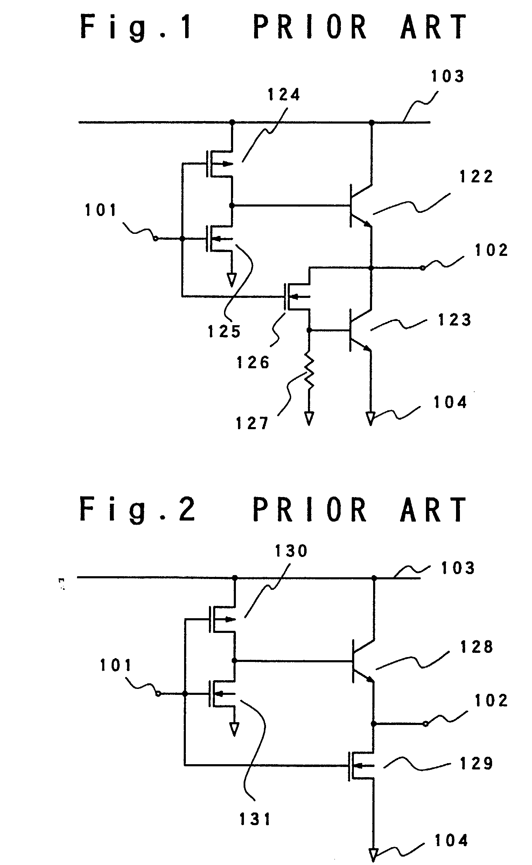

First, a conventional BiMOS semiconductor circuit will be described below. Fig. 1 is a circuitry block diagram showing a conventional BiCMOS inverter circuit having a simple circuit structure. Referring to Fig. 1, the conventional BiCMOS inverter is provided with two bipolar transistors 122 and 123 which constitute a push-pull buffer. The collector of the first bipolar transistor 122 is connected to a high voltage side power supply line 103 of a potential Vcc, the emitter thereof is connected to the output terminal 102 together with the collector of the second bipolar transistor 123. The emitter of the second bipolar transistor 123 is connected to a low voltage power supply line or a ground potential GND 104. The source of a P-channel MOS FET (to be referred to as "PMOS transistor" hereinafter) 124 is connected to the Vcc power supply line 103 and the drain thereof is connected to the base of the first bipolar transistor 122 together with the drain of a first N-channel MOS FET (to be referred to as "NMOS transistor" hereinafter) 125. The source of the first NMOS transistor 125 is connected to the ground potential GND 104. Further, a second NMOS transistor 126 is provided such that the drain thereof is connected to the output terminal 102 and the source thereof is connected to the second bipolar transistor 123 and one terminal of a resistor 127. The other terminal of the resistor element 127 is connected to the ground potential GND 104. The gates of the PMOS transistor 124, first NMOS transistor 125 and second NMOS transistor 126 are connected to an input terminal 101.

Next, the operation of the conventional BiCMOS inverter circuit will be described below.

The transition process of the potential of the input terminal 101 from a high level to a low level will be first described. When the potential of the input terminal 101 transits from the high level to the low level, the PMOS transistor 124 is turned on and the NMOS transistors 125 and 126 change to the off state. As a result, a base stray capacitor of the first bipolar transistor 122 is charged up by a current from the Vcc power supply line 103 through the PMOS transistor 124. When the base potential of the first bipolar transistor 122 is equal to a forward direction bias VF between the base and the emitter, the first bipolar transistor 122 is turned on. Therefore, a capacitive load connected to the output terminal 102 such as another MOS logic circuit and a wiring pattern is charged and the potential of the output terminal 102 rises while keeping a potential state in which the potential of the output terminal 102 is lower than the base potential of the first bipolar transistor 122 by the forward direction bias VF. Since the second NMOS transistor 126 is also turned off, current is not supplied to the base of the second bipolar transistor 123. Also, charge stored in the base of the second bipolar transistor 123 is discharged to the GND 104 through the resistor 127. As a result, the bipolar transistor 123 is turned off. Therefore, the potential of the output terminal 102 changes from the low level to the high level. When the potential of the output terminal 102 rises to a potential lower than the potential Vcc of the power supply line 103 by the forward direction bias VF, the first bipolar transistor 122 is turned off. The capacitive load connected to the output terminal 102 is charged no longer and the potential of the output terminal is set in a high level state equal to (Vcc - VF).

The transition process of the potential of the input terminal 101 from the low level to the high level will be next described. When the potential of the input terminal 101 transits from the low level to the high level, the PMOS transistor 124 is turned off and the NMOS transistors 125 and 126 change to the on state. Finally, the base current of the first bipolar transistor 122 is cut off, so that the first bipolar transistor 122 is turned off. The second NMOS transistor 126 is also turned on, so that a base stray capacitor of the second bipolar transistor 123 is charged. When the base potential of the second bipolar transistor 123 rises to the forward direction bias VF, the second bipolar transistor 123 is turned on and as a result of this the load connected to the output terminal 102 is discharged quickly. Therefore, the potential of the output terminal 102 changes from the high level to the low level.

Next, a conventional BiNMOS inverter circuit will be described. The circuitry diagram is shown in Fig. 2. In the conventional BiNMOS inverter circuit, the collector of an NPN bipolar transistor 128 is connected to the Vcc power supply line 103, the emitter thereof is connected to the output terminal 102, and the base thereof is connected to the drain of a PMOS transistor 130 and the drain of a first NMOS transistor 131. The source of the first PMOS transistor 130 is connected to the Vcc power supply line 103 and the source of the first NMOS transistor 31 is connected to a ground line GND 104. Further, the drain of a second NMOS transistor 129 is connected to the output terminal 102, and the source thereof is connected to the ground line GND 104. The gates of the PMOS transistor 130, and first and second NMOS transistors 131 and 129 are connected to the input terminal 101.

BiCMOS gate circuit and BiNMOS gate circuit have been proposed to have various circuit types other than the circuit types as described above. In any of the BiCMOS gate circuits and BiNMOS gate circuits the collector of an NPN bipolar transistor for charging and driving an output load and the source of the MOS transistor for driving and charging the base of the bipolar transistor are connected to a common high voltage side power supply line. Even if different power supply lines are provided, there are many cases where one of the power supply lines is supplied externally.

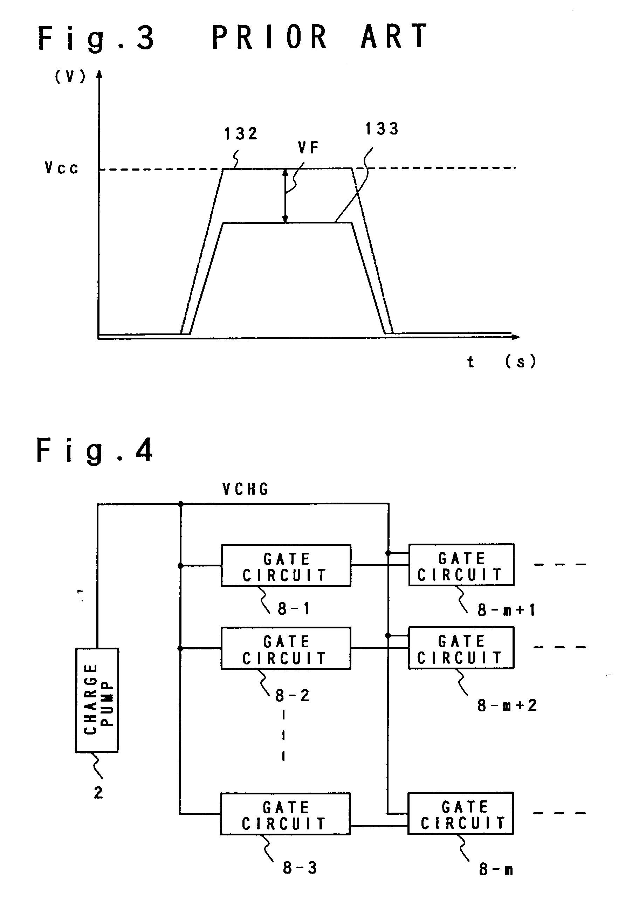

Fig. 3 is a waveform diagram upon the operation of the BiNMOS gate circuit shown in Fig. 2. The operational voltage waveform of the base of the NPN bipolar transistor 128 shown in Fig. 2 has an amplitude between the high potential Vcc and the ground potential GND as shown in Fig. 3 as a waveform 132, while the operational voltage waveform of the output terminal 102 has a waveform which the high level is lower than the high potential Vcc by the forward direction bias VF, as shown as a waveform 133.

In the conventional BiMOS semiconductor integrated circuit including BiCMOS logic gate circuits or BiNMOS logic gate circuits, when a bipolar transistor connected to the output terminal is turned on so that the output terminal potential is pulled up to a high level, the potential at the high level is lower than the potential on the high voltage side power supply line by the forward direction bias VF. This voltage drop is determined based on an energy band gap of silicon as a material of the bipolar transistor and indicates a constant value. On the other hand, a power supply voltage has been recently decreased because of the problem of reliability over hot electron generation in MOS transistors and the problem of power consumption.

As a result, when the power supply voltage is decreased, there are caused problems of decreasing of noise margin and lowering of operation speed because the amplitude of an output logic is small.

In order to solve the problems, there is a case where a plurality of power supply lines are provided. In this case, two types of high voltage side must be supplied externally or an internal voltage dropping circuit must be provided. As a result, there is caused a problem in that cost is increased and power consumption cannot be decreased.

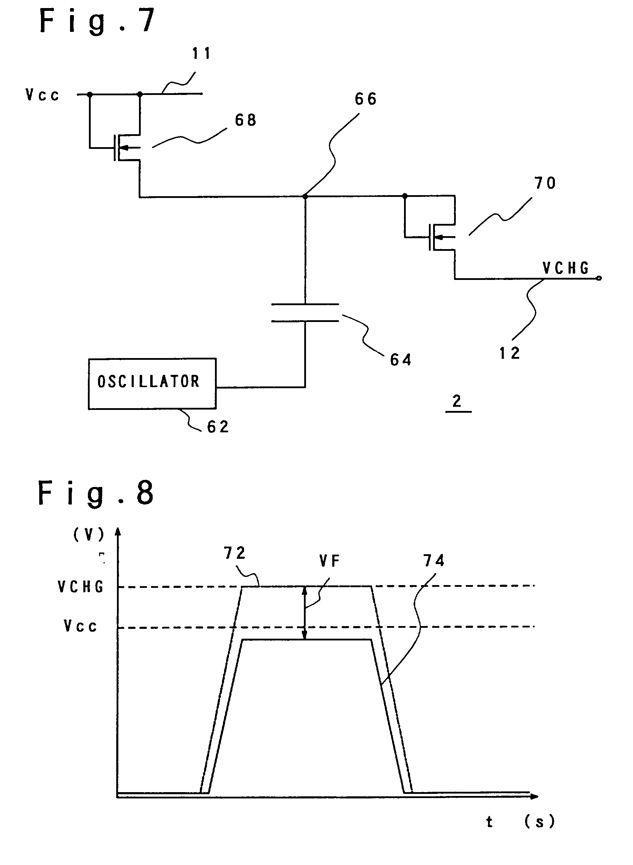

It can be considered that the power supply voltage is boosted up by a charge pump as in a DRAM or the like in which the voltage of a word line is boosted up (IEEE Journal of Solid State Circuit, Vol. 25, No. 5, Oct., 1990, Fig. 6). In this method, current for charging and discharging a word line load must be supplied with the boosted voltage. However, the current drive capability of the charge pump is limited. Therefore, the boosting operation cannot be applied to the power supply circuit which high current drive capability is required as in a random logic.

Further, in order to improve such situation, there is an example in which a P-channel MOS transistor is added in parallel to an output pulling-up bipolar transistor of a BiCMOS or BiNMOS transistor logic gate circuit. However, there is drawback in that a capacitor at the input terminal is increased or a layout area required is increased.

EP-A-307 323 mentions the possibility of supplying the FET logic circuit and the output transistors with two different voltages.

### Summary of the Invention

Therefore, the present invention has, as an object, to provide a BiMOS semiconductor integrated circuit in which two types of different power supply lines can be used without being provided externally.

Another object of the present invention is to provide a BiMOS semiconductor integrated circuit in which a voltage boosted up from a power supply voltage by a boosting circuit is used to drive a bipolar transistor and therefore the boosting circuit is not required to have a large current capacity.

Still another object of the present invention is to provide a BiMOS semiconductor integrated circuit in which a relatively large noise margin can be achieved in a low voltage operation without almost lowering the operation speed.

In order to achieve an aspect of the present invention, a BiMOS semiconductor integrated circuit includes a boosting section for boosting a first potential on a first power supply line to supply the boosted potential on a second power supply line as a second potential, a driving section connected to an output terminal and including a bipolar transistor, for driving a load connected to the output terminal by the bipolar transistor, and a driving control section connected to the second power supply line and at least one input terminal, and having a plurality of MOS FETs, for performing a logic calculation on input supplied to the at least one input terminal to supply a base current from the second power supply line to a base of said bipolar transistor in accordance with the logic calculation result such that the driving section drives the output load.

In order to achieve another aspect of the present invention, a BiMOS semiconductor integrated circuit includes a voltage boosting section connected to a first power supply line having a first potential, for boosting the first potential to supply the boosted potential as a second potential on a second power supply line, and a circuit section including:
an output section connected to an output terminal and a first power supply line and including a bipolar transistor, one of an emitter and an collector of the bipolar transistor being connected to the first power supply line and the other being connected to the output terminal, for driving a load connected to said output terminal, and
a logic calculation section connected to the second power supply line, at least one input terminal, and a base of the bipolar transistor and comprising a plurality of MOS FETs, for performing a logic calculation on input supplied to the one input terminal and selectively passing the base current to the base of the bipolar transistor from the second power supply line in accordance with the logic calculation result such that said output section can drive the load.

In this case, the voltage boosting section may include an oscillator circuit generating an oscillation signal, a capacitor to one terminal of which the oscillation signal is supplied, and a charging/discharging circuit connected to the first and second power supply lines, for charging gradually the capacitor to a voltage higher than the first potential on said first power supply line in response to the supply of said oscillation signal to the capacitor. The frequency of the oscillation signal may be predetermined to be a constant value, based on a difference between the first potential and the second potential. The oscillator circuit may include a circuit for controlling a frequency of the oscillation signal based on the boosted potential from the first potential. The boosting circuit preferably includes an element for keeping a difference between the first and second potentials constant. The element may be either a diode or a MOS FET connected so as to construct the diode.

In this manner, a MOS transistor for charging and driving a base of an NPN bipolar transistor for pulling up is connected to a boosted voltage power supply line having a potential boosted higher than a high voltage side power supply line by a charge pump in a BiCMOS gate circuit. Therefore, If the potential difference between the boosted voltage power supply line and the high voltage side power supply line is set to be in a range of about 0.5 to 0.7 V not so as to make the bipolar transistor to saturate, the high level of the output terminal can rise up to a potential lower than that of the boosted voltage power supply line by forward direction bias VF, that is, a potential almost equal to the high voltage side power supply voltage. Thereby, the high speed and stable operation of the BiMOS semiconductor integrated circuit such as BiCMOS gate circuits and BiCMOS gate circuits can be achieved in a case of use of a low voltage power supply. It should be noted that the charge pump may have a small current drive capability because a bipolar transistor typically has a great current amplification factor, and further the single charge pump can be connected to a plurality of BiCMOS or BiNMOS gate circuits which are formed on the same substrate as the charge pump.

### Brief Description of the Drawings

Fig. 1 is a circuit block diagram showing a conventional BiCMOS gate circuit;
Fig. 2 is a circuit block diagram showing a conventional BiNMOS gate circuit;
Fig. 3 is a diagram showing the operation waveforms of the conventional BiNMOS transistor gate circuit shown in Fig. 2;
Fig. 4 is a block diagram showing a BiMOS semiconductor integrated circuit according to an embodiment of the present invention;
Fig. 5 is a circuit block diagram showing a BiCMOS logic gate circuit used in the embodiment of the present invention;
Fig. 6 is a circuit block diagram showing a BiNMOS logic gate circuit used in the embodiment of the present invention;
Fig. 7 is a circuit diagram showing a charge pump used in the embodiment shown in Fig. 4;
Fig. 8 is a diagram showing the operation waveform of the BiNMOS logic gate circuit used in the embodiment shown in Fig. 6;
Fig. 9 is a circuit block diagram showing another BiCMOS logic gate circuit used as an NAND gate circuit in the embodiment of the present invention;
Fig. 10 is a circuit block diagram showing another BiCMOS logic gate circuit used as an NOR gate circuit in the embodiment of the present invention;
Fig. 11 is a circuit diagram showing a modification of the charge pump;
Fig. 12 is a circuit diagram showing another modification of the charge pump; and
Fig. 13 is a circuit diagram showing still another modification of the charge pump.

### Description of the Preferred Embodiments

The present invention will be described below with reference to the accompanying drawings.

Fig. 4 is a block diagram showing a BiMOS semiconductor integrated circuit formed on a same substrate according to an embodiment of the present invention. Referring to Fig. 4, the BiMOS semiconductor integrated circuit includes a charge pump 2 for boosting up a potential Vcc on a first high voltage side power supply line to produce a boosted potential VCHG on a second power supply line, and a plurality of BiMOS logic gate circuits 8 (8-1, 8-2, ..., 8-m, ..., 8-n). The boosted potential VCHG is supplied to the plurality of BiMOS logic gate circuits 8.

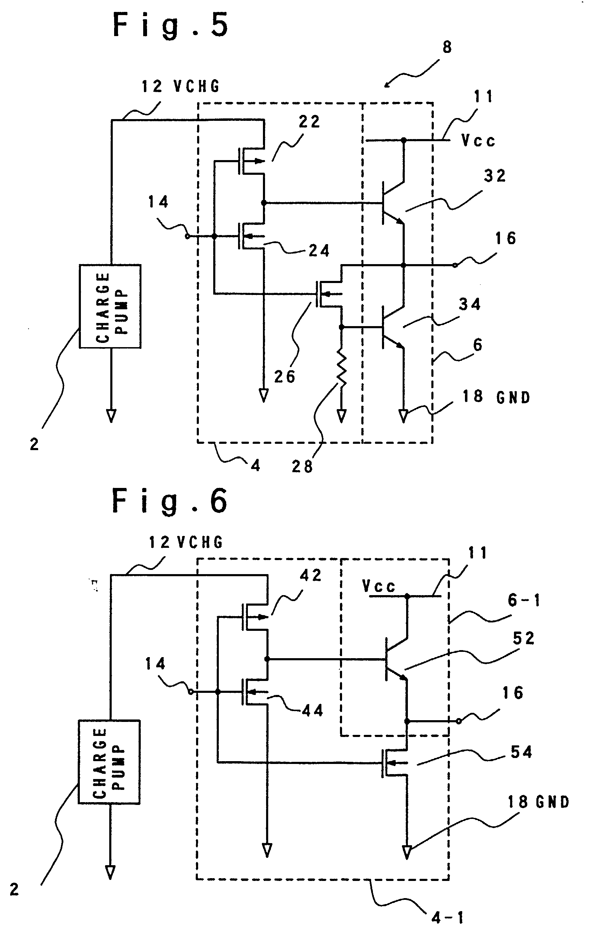

Fig. 5 is a circuit block diagram showing a BiCMOS inverter circuit used as one of the plurality of BiMOS logic gate circuits 8 in the embodiment of the present invention. The BiMOS inverter circuit is composed of a logic calculation section 4 and an output driving section 6. The collector of a first NPN bipolar transistor 32 in the output driving section 6 is connected to a high voltage side power supply line 11 of the voltage Vcc, the emitter thereof is connected to an output terminal 16, and the base thereof is connected to the drain of a PMOS transistor 22 and the drain of a first NMOS transistor 24 in the logic calculation section 4. Further, the collector of a second bipolar transistor 34 in the output driving section 6 is also connected to the output terminal 16, and the emitter thereof is connected to a low voltage side power supply line GND 18.

The source of the first NMOS transistor 24 is connected to the low voltage side power supply ling GND 4. The drain of a second NMOS transistor 26 in the logic calculation section 4 is also connected to the output terminal 16 and the source of thereof is also connected to the base of the of the second bipolar transistor 34. Further, a resistor element 28 is connected between the base of the second NPN bipolar transistor 34 and the low voltage side power supply line GND 4, for discharging base charge of the second NPN bipolar transistor 34. The source of the PMOS transistor 22 is connected to a second power supply 12 having the boosted voltage VCHG by the charge pump 2. All of the gate of the PMOS transistor 22, the gate of the first NMOS transistor 24, and the gate of the second NMOS transistor 26 are connected to an input terminal 14.

Next, the charge pump 2 will be described below. As the charge pump 2 can be generally used a circuit such as a word line voltage boosting circuit for a DRAM (dynamic random access memory). For instance, the circuit shown in Fig. 7 may be used. Referring to Fig. 7, the charge pump 2 includes an oscillator 62, a capacitor 64 connected to the oscillator 62 and a boosted node 66, and NMOS transistors 68 and 70. The gate and drain of the NMOS transistor 68 are connected to the Vcc power supply line 11 and the source thereof is connected to the boosted node 66. The drain and gate of an NMOS transistor 70 are connected to the boosted node 66 and the source thereof is connected to the VCHG power supply line 12. It should be noted that the NMOS transistor 68 and 70 construct a so-called diode connection. Therefore, there is no case that current flows into the boosted node 66 from the VCHG power supply line 12.

Next, the operation of the BiMOS semiconductor integrated circuit will be described below.

The oscillator 62 oscillates to supply an oscillation signal having a predetermined frequency to the capacitor 64. The capacitor 64 is driven in response to the oscillation signal. When the capacitor 64 is driven with the rising edge of the oscillation signal, no charge is supplied from the Vcc power supply line 11. However, when the capacitor 64 is driven with the falling edge of the oscillation signal, charge is supplied from the Vcc power supply line 11 through the NMOS transistor 68 as a diode and stored in the capacitor 64. In this manner, the capacitor 64 can be gradually charged up to a voltage Vcc - V_{T} (V_{T} is the threshold voltage of Nmos 68) because the stray capacitance around the boosted node is sufficiently small compared to the capacitance of the capacitor 64, in a case that an amount of current required to charge a load is small. Therefore, under the above-mentioned ideal condition, the potential on the VCHG power supply line 12 can rise to a potential obtained by subtracting a threshold voltage VT of the NMOS transistor 70 from a potential Vcc - V_{T}. In this embodiment, the capacitor 64 has a capacitance of 5 to 10 pF and the frequency of the oscillation signal is 250 MHz. As a result, 120 BiMOS logic gate circuits could be driven.

Next, the operation of the BiMOS inverter circuit will be described below.

The transition process of an input potential from a low level to a high level will be first discussed. When the input level changes from the low level to the high level, since the PMOS transistor 22 changes from the on state to the off state, the base potential of the first bipolar transistor 32 is decreased and base current supplied from the VCHG power supply line 12 is also decreased. As a result, the potential of the output terminal 16 of the inverter is also decreased. At the same time, the first NMOS transistor 24 is turned on, so that a base stray capacitor of the first bipolar transistor 32 is discharged quickly. Also, since the second NMOS transistor 26 changes from the off state to the on state, the second bipolar transistor 34 is turned on, so that charge of a load connected to the output terminal 16 is quickly discharged. Finally, the base current of the first bipolar transistor 32 is cut off, so that the first bipolar transistor 32 is turned off. Therefore, the potential of the output terminal 16 changes from the high level to the low level.

Next, The transition process of the input level from the high level to the low level will be described. When the input level of the input terminal 14 changes from the high level to the low level, the PMOS transistor 22 changes from the off state to the on state while the NMOS transistors 24 and 26 changes from the on state to the off state. At this time, the base potential of the first bipolar transistor 32 rises and the base current is supplied from the VCHG power supply line 12 to the bipolar transistor 32 through the PMOS transistor 22. As a result, the bipolar transistor 32 is turned on, so that the level of output terminal 16 rises, keeping the level lower than the base potential by the forward direction bias VF, while charging the load connected to the output terminal 16. When the first bipolar transistor 32 is turned off when the potential of output terminal 16 reaches a potential lower than the potential VCHG by the forward direction bias VF, the bipolar transistor 32 stops supplying the current to the load connected to the output terminal 16. Since the NMOS transistor 26 changes from the on state to the off state, the second bipolar transistor 34 is turned off.

Fig. 6 is a circuit block diagram showing a BiNMOS inverter circuit according to an embodiment of the present invention. Referring to Fig. 6, the collector of an NPN bipolar transistor 52 in the output driving section 6-1 is connected to the Vcc power supply line 11, the emitter thereof is connected to the output terminal 16, and the base thereof is connected to the drain of a PMOS transistor 42 and the drain of a first NMOS transistor 44 in the logic calculation section 4-1. Further, the source of the first NMOS transistor 44 is connected to the GND 18. Further, a second NMOS transistor 54 in the logic calculation section 4-1 is provided to have the source connected to the GND 18 and the drain connected to the output terminal 16. The gate of the PMOS transistor 42, and the gates of the first and second NMOS transistors 44 and 54 are connected to the input terminal 14. Furthermore, the source of the PMOS transistor 42 is connected to the VCHG power supply line 12 which is set to a potential boosted by the charge pump 2. It should be noted that the electric field between the source and drain of the first NMOS transistor 44 can be reduced by inserting an element such as a diode between the source of the first NMOS transistor 44 and the GND 18, in a case where there is caused a problem of generation of hot carriers because the voltage VCHG is applied between the source and drain of the first NMOS transistor 44.

Next, the operation of the BiNMOS inverter circuit will be described below.

The transition process of an input potential from a low level to a high level will be first discussed. When the input signal to the input terminal 14 changes from the low level to the high level, the PMOS transistor 42 changes from the on state to the off state and the base potential of the first bipolar transistor 52 is decreased. At the same time, the second NMOS transistor 54 is turned on, so that charge of the load connected to the output terminal 16 is discharged.

Next, the transition process of the input level from the high level to the low level will be described. When the input level of the input terminal 14 changes from the high level to the low level, the PMOS transistor 42 changes from the off state to the on state, base current is passed through the PMOS transistor 42 from the VCHG power supply line 12 to the bipolar transistor 52 and the base potential of the bipolar transistor 52 is increased. At the same time, the first and second NMOS transistors 44 and 54 are turned off. As a result, the potential of output terminal 16 rises while keeping the potential lower than the base potential by the forward direction bias VF. Finally, the bipolar transistor 52 is turned off when the potential of the output terminal 16 reaches the potential lower than the potential VCHG by the forward direction bias VF and stops supplying current to the load connected to the output terminal 16.

In the above description, in a case where the potential VCHG is boosted up to a potential Vcc - 2V_{T} which is higher than the voltage Vcc by more than V_{T}, when the input level of the input terminal 14 is in the low level, each of the bipolar transistor 32 shown in Fig. 5 and the bipolar transistor 52 shown in Fig. 6 is in the saturation region. Therefore, the switching speed of the bipolar transistor is late and thereby the operation speed of the BiMOS gate circuit is also decreased. The boosted potential VCHG is preferably in a potential range in which the bipolar transistor is in a region other than the saturation region. If the potential VCHG is set to be a potential higher than the potential Vcc by about 0.6 V, it is possible to pull up the output potential of the output terminal 16 to substantially the same potential as the potential Vcc, the voltage of 0.2 to 0.3 V between the collector and the emitter can be obtained in the bipolar transistor 32 or 52. In this case, if the frequency of the oscillation signal from the oscillator 62 in the charge pump 2 is small, the charged voltage of the capacitor 64 or the boosted potential VCHG could be set to a desired value.

The charge pump 2 needs not to always have a large current drive capability for supplying the potential VCHG, because the NPN bipolar transistor typically has a current amplification factor as great as 50 to 100, and the base current of the first bipolar transistor is supplied only when the output voltage is to be increased. As described above, a single charge pump 2 can supply the potential VCHG to a large number of BiMOS gate circuits.

Fig. 8 shows the operation waveforms of the BiNMOS inverter circuit shown in Fig. 6 and used in the BiMOS semiconductor integrated circuit according to the present invention. The operation waveform of the base potential of the NPN bipolar transistor 52 when the input level of the input terminal 14 changes from the high level to the low level and further to the high level is shown by a line 72. The potential of the output terminal 16 is shown by a line 74 under the same condition. As seen in the figure, the output terminal potential is a potential lower than the potential of the waveform 72 by the forward direction bias VF when the input level is in the low level. In this example, the output terminal potential is close to the potential Vcc and the bipolar transistor 52 is not in the saturation region.

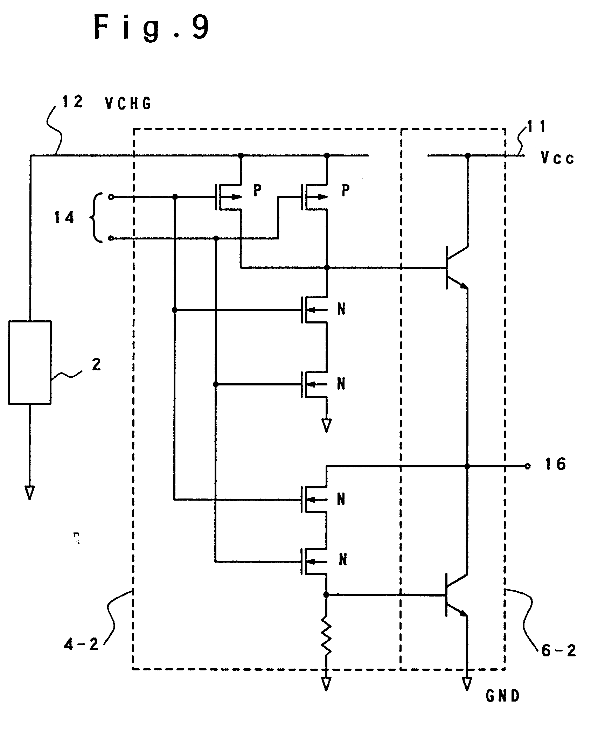

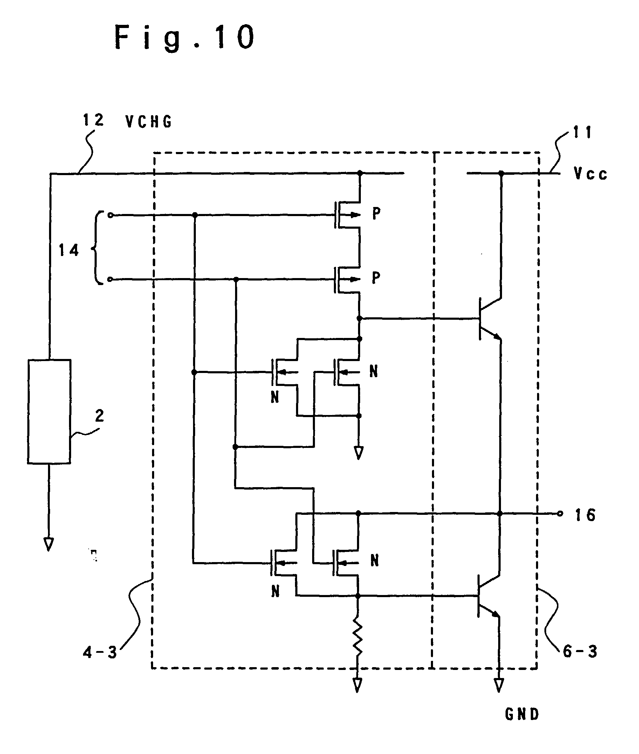

The BiMOS semiconductor integrated circuit according to the present invention was described taking as an example the inverter circuit such as the BiCMOS inverter circuit and the BiNMOS inverter circuit. However, the present invention can be applied to a circuit having more complicated logic circuit. For instance, the present invention may be applied to an NAND gate circuit shown in Fig. 9 and an NOR gate circuit shown in Fig. 10. The structure and operation of the NAND gate and NOR gate are well known in the art and hence the description will be omitted. Further, the present invention can be applied to a flip-flop circuit. Furthermore, the present invention can be applied to another type of BiCMOS circuit and BiNMOS circuit without departing from the scope of the present invention. For instance, a PNP transistor may be used in place of the NPN bipolar transistor.

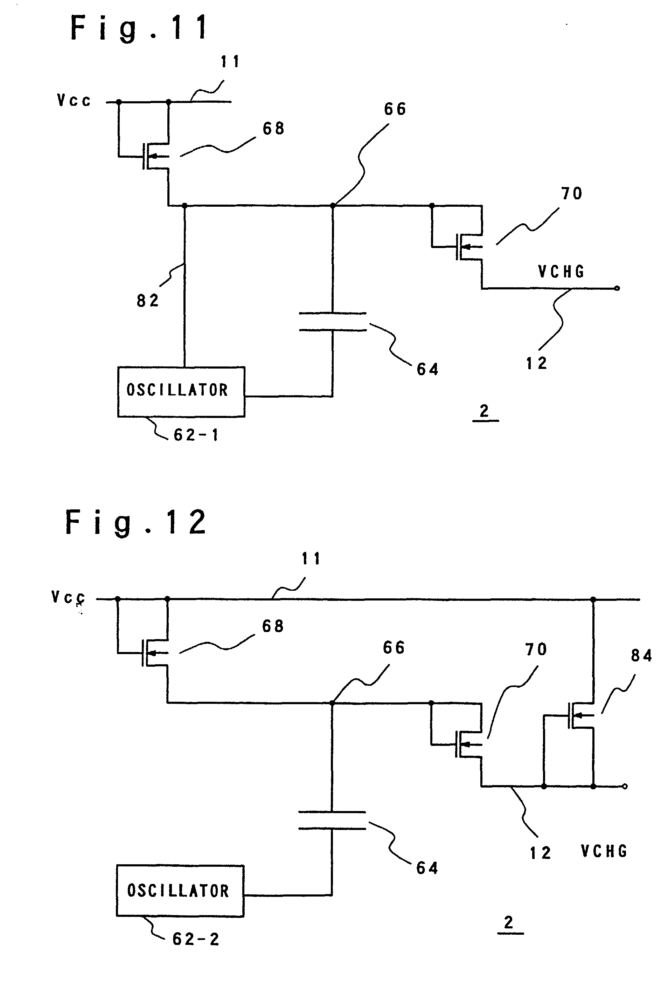

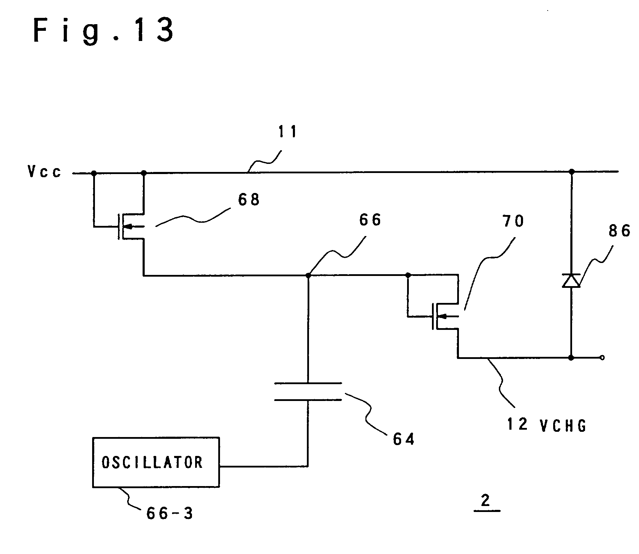

In the above description, the boosted potential VCHG is fixedly determined based on the frequency of the oscillation signal from the oscillator 62. In order to stabilize the potential VCHG, the charge pump 2 shown in Figs. 11 to 13 may be employed. Referring to Fig. 11, the boosted potential VCHG is fed back to the oscillator 62-1. The oscillator 62-1 is of a type in which the frequency of the oscillation signal is controlled by an input voltage. Thus, the oscillator 62-1 generates the oscillation signal such that the boosted potential VCHG has a constant value. In the above example, the frequency of the oscillation signal is controlled. However, another element may be added to stabilized the boosted potential VCHG. In the charge pump shown in Fig. 12, an NMOS transistor 84 having a diode connection is added between the Vcc power supply line 11 and the VCHG power supply line 12. As a result, the potential VCHG on the line 12 is never increased higher than 0.6 V from the potential Vcc. In this example, the potential VCHG is stabilized sufficiently although small current loss is caused. In an example shown in Fig. 13, a diode 86 is used in place of the NMOS transistor 84 of Fig. 12. The effect is the same as the case shown in Fig. 12.

As described above, according to the present invention, in the BiMOS semiconductor integrated circuit such as a BiCMOS circuit or BiNMOS circuit using an NPN bipolar transistor for charging a load, the potential level of the output terminal in the high level state can be prevented from being decreased by supplying base current from a power supply line having a potential boosted up by a charge pump to the NPN transistor through a PMOS transistor. Therefore, a large noise margin can be achieved in a case of using a low voltage power supply such as battery. Further, decrease in the operation speed in a case of using a low voltage power supply can be suppressed to a negligible extent. In addition, the present invention has the advantage in that the input terminal capacitance of the BiMOS gate circuit is not increased, compared to a case where a PMOS transistor is connected in parallel to the NPN bipolar transistor for charging the load.

## Claims

1. A BiMOS semiconductor integrated circuit comprising:
a voltage boosting section (2) connected to a first power supply line (11) having a first potential, for boosting the first potential to supply the boosted potential as a second potential on a second power supply line (12); and
a circuit section (8) including:
an output section (6) connected to an output terminal (16) and to the first power supply line and including a bipolar transistor (32; 52), one of an emitter and an collector of the bipolar transistor being connected to the first power supply line and the other being connected to the output terminal, for driving a load connected to said output terminal; and
a logic calculation section (4) connected to the second power supply line, at least one input terminal (14), and a base of the bipolar transistor and comprising a plurality of MOS FETs (22 to 26; 42 to 44), for performing a logic calculation on input supplied to said at least one input terminal and selectively passing the base current to the base of the bipolar transistor from said second power supply line in accordance with the logic calculation result such that said output section can drive the load.

2. A BiMOS semiconductor integrated circuit according to claim 1, wherein said voltage boosting section comprises:
an oscillator circuit (62) generating an oscillation signal;
a capacitor (64) to one terminal of which said oscillation signal is supplied; and
a charging/discharging circuit (68 and 70) connected to said first and second power supply lines, for charging gradually said capacitor to a voltage higher than said first potential on said first power supply line in response to the supply of said oscillation signal to said capacitor.

3. A BiMOS semiconductor integrated circuit according to claim 2, wherein a frequency of the oscillation signal is predetermined to be a constant value, based on a difference between said first potential and said second potential.

4. A BiMOS semiconductor integrated circuit according to claim 2, wherein said voltage boosting section further includes means (82) for feeding back a data indicative of the second potential such that said oscillator circuit can controls a frequency of the oscillation signal based on the boosted potential from said first potential.

5. A BiMOS semiconductor integrated circuit according to claim 2, wherein said boosting circuit further includes an element (84; 86) for keeping a difference between said first and second potentials constant.

6. A BiMOS semiconductor integrated circuit according to claim 5, wherein said element comprises either a diode (86) or a MOS FET (84) connected so as to construct the diode.

7. A BiMOS semiconductor integrated circuit according to any one of claims 1 to 6, wherein said voltage boosting section and said circuit section are formed on the same substrate.

8. An BiMOS semiconductor integrated circuit according to any one of claims 1 to 7, further comprising a plurality of said circuit sections connected to said voltage boosting section.

## Patentansprüche

1. Ein integrierter BiMOS-Halbleiter-Schaltkreis, der folgendes aufweist:
einen Spannungserhöhungs-Abschnitt (2), der mit einer ersten Stromversorgungs-Leitung (11) mit einem ersten Potential verbunden ist, zur Erhöhung des ersten Potentials, um das erhöhte Potential als ein zweites Potential auf einer zweiten Stromversorgungs-Leitung (12) zuzuführen; und
einen Schaltkreisabschnitt (8), der folgendes aufweist:
einen Ausgangsabschnitt (6), der mit einem Ausgangsanschluß (16) und mit der ersten Stromversorgungs-Leitung verbunden ist und einen bipolaren Transistor (32; 52) aufweist, wobei entweder der Emitter oder der Kollektor des bipolaren Transistors mit der ersten Stromversorgungs-Leitung verbunden ist und der andere mit dem Ausgangsanschluß verbunden ist, zum Antreiben einer mit dem Ausgangsanschluß verbundenen Last; und
einen logischen Berechnungsabschnitt (4), der mit der zweiten Stromversorgungs-Leitung, mindestens einem Eingangsanschluß (14) und einer Basis des bipolaren Transistors verbunden ist und eine Vielzahl von MOS-FETs (22 bis 26; 42 bis 44) aufweist, zur Ausführung einer logischen Berechnung mit einem dem mindestens einem Eingangsanschluß zugeführten Eingangssignal und wahlweisen Leitung des Basisstroms von der zweiten Stromversorgungs-Leitung zur Basis des bipolaren Transistors, entsprechend dem Ergebnis der logischen Berechnung, so daß der Ausgangsabschnitt die Last antreiben kann.

2. Integrierter BiMOS-Halbleiter-Schaltkreis nach Anspruch 1, dadurch gekennzeichnet, daß der Spannungserhöhungs-Abschnitt folgendes aufweist:
einen Oszillatorkreis (62), der ein Oszillationssignal erzeugt;
einen Kondensator (64), einem Anschluß dessen das Oszillationssignal zugeführt wird; und
einen Ladungs/Entladungs-Schaltkreis (68 und 70), der mit der ersten und zweiten Stromversorgungs-Leitung verbunden ist, zur schrittweisen Ladung des Kondensators auf eine höhere Spannung als das erste Potential auf der ersten Stromversorgungs-Leitung ansprechend auf das Zuführen des Oszillationssignals zum Kondensator.

3. Integrierter BiMOS-Halbleiter-Schaltkreis nach Anspruch 2, dadurch gekennzeichnet, daß eine Frequenz des Oszillationssignal so vorher festgelegt ist, daß sie einen konstanten Wert aufweist, der auf einer Differenz zwischen dem ersten Potential und dem zweiten Potential basiert.

4. Integrierter BiMOS-Halbleiter-Schaltkreis nach Anspruch 2, dadurch gekennzeichnet, daß der Spannungserhöhungs-Abschnitt weiterhin eine Vorrichtung (82) zur Rückkopplung eines Datums aufweist, das das zweite Potential anzeigt, so daß der Oszillatorkreis eine Frequenz des Oszillationssignals basierend auf dem vom ersten Potential erhöhten Potential steuern kann.

5. Integrierter BiMOS-Halbleiter-Schaltkreis nach Anspruch 2, dadurch gekennzeichnet, daß der Erhöhungs-Schaltkreis weiterhin ein Element (84; 86) zur Konstanthaltung einer Differenz zwischen dem ersten und dem zweiten Potential aufweist.

6. Integrierter BiMOS-Halbleiter-Schaltkreis nach Anspruch 5, dadurch gekennzeichnet, daß das Element entweder eine Diode (86) oder einen MOS-FET (84) aufweist, der so angeschlossen ist, daß er die Diode bildet.

7. Integrierter BiMOS-Halbleiter-Schaltkreis nach einem der Ansprüche 1 bis 6, dadurch gekennzeichnet, daß der Spannungserhöhungs-Abschnitt und der Schaltkreis-Abschnitt auf demselben Substrat ausgebildet sind.

8. Integrierter BiMOS-Halbleiter-Schaltkreis nach einem der Ansprüche 1 bis 7, dadurch gekennzeichnet, daß dieser weiterhin eine Vielzahl der Schaltkreis-Abschnitte aufweist, die mit dem Spannungserhöhungs-Abschnitt verbunden sind.

## Revendications

1. Un circuit intégré à semi-conducteur BiMOS comprenant:
une section élévation de voltage (2) reliée à une première ligne d'alimentation en courant (11) ayant un premier potentiel, pour élever le premier potentiel afin de fournir le potentiel élevé comme deuxième potentiel sur une deuxième ligne d'alimentation en courant (12); et une section circuit (8) comprenant:
une section puissance, reliée à un terminal de sortie (16) et à la première ligne d'alimentation en courant et comprenant un transistor bipolaire (32; 52), l'un des émetteurs et un collecteur du transistor bipolaire étant relié à la première ligne d'alimentation et l'autre étant relié au terminal de sortie, pour commander une charge reliée audit terminal de sortie; et
une section logique de calcul (4) reliée à la deuxième ligne d'alimentation en courant, à au moins un terminal d'entrée (14), et à une base du transistor bipolaire et comprenant une pluralité de transistors MOS à effet de champ (22 à 26; 42 à 44), pour effectuer un calcul logique sur l'entrée fournie audit au moins un terminal d'entrée et passer sélectivement le courant de base à la base du transistor bipolaire de ladite deuxième ligne d'alimentation en accord avec le résultat du calcul logique tel que ladite section de sortie puisse commander la charge.

2. Un circuit intégré à semi-conducteur BiMOS selon la revendication 1, dont ladite section d'élevage de voltage comprend:
un circuit d'oscillation (62) qui produit un signal d'oscillation;
un condensateur (64) à un terminal duquel ledit signal d'oscillation est fourni; et
un circuit de charge/décharge (68 et 70) relié audites première et deuxième lignes d'alimentation en courant, afin de charger progressivement ledit condensateur à un voltage plus élevé que ledit premier potentiel sur ladite première ligne d'alimentation en courant en réponse à la fourniture de ladite signal d'oscillation audit condensateur.

3. Un circuit intégré à semi-conducteur BiMOS selon la revendication 2, où une fréquence du signal d'oscillation est prédéterminée comme valeur constante, basée sur une différence entre ledit premier potentiel et ledit deuxième potentiel.

4. Un circuit intégré à semi-conducteur BiMOS selon la revendication 2, caractérisé en ce que ladite section d'élévation de voltage comprend en outre un moyen (82) pour retourner une donnée qui indique le deuxième potentiel, tel que ledit circuit d'oscillateur puisse commander une fréquence du signal d'oscillation, sur la base du potentiel élevé dudit premier potentiel.

5. Un circuit intégré à semi-conducteur BiMOS selon la revendication 2, caractérisé en ce que ledit circuit d'élévation inclut en outre un élément (84; 86) pour garder une différence constante entre lesdits premiers et deuxième potentiels.

6. Un circuit intégré à semi-conducteur BiMOS selon la revendication 5, caractérisé en ce que ledit élément comprend ou une diode (86) ou un dispositif MOS à effet de champ (84) connectés afin de construire la diode.

7. Un circuit intégré à semi-conducteur BiMOS selon une ou toutes les revendications 1 à 6, caractérisé en ce que ladite section d'élévation de voltage et ladite section de circuit soient formées sur le même substrat.

8. Un circuit intégré à semi-conducteur BiMOS selon une ou toutes les revendications 1 à 7, comprenant en outre une pluralité desdites sections de circuit reliées à ladite section d'élévation de voltage.
